# EUROPEAN PATENT APPLICATION

(11) **EP 4 739 008 A1**
(43) Date of publication of application: **06.05.2026**
(21) Application number: 24855196.2
(22) Date of filing: 15.01.2024
(51) Int. Cl.: H05K 5/02, H05K 7/18, H05K 7/14

(54) **COMMUNICATION DEVICE FRAME AND COMMUNICATION DEVICE**

(30) Priority: 23.08.2023 CN 202322284637 U
(71) Applicant: Huawei Technologies Co., Ltd., Shenzhen, Guangdong 518129 (CN)
(72) Inventor: LIU, Detong, Shenzhen, Guangdong 518129 (CN); HUANG, Lezheng, Shenzhen, Guangdong 518129 (CN); LIU, Jiangfeng, Shenzhen, Guangdong 518129 (CN)
(74) Representative: Gill Jennings & Every LLP
(86) International application number: PCT/CN2024/072299
(87) International publication number: WO 2025/039461

(57) **Abstract**

This application provides a communication device subrack and a communication device. The subrack includes a body and a rotating member. A sliding groove is disposed on the body, where the sliding groove extends in a first direction, and the first direction is perpendicular to a height direction of the communication device subrack. The rotating member is rotatably disposed on the body and at least partially located in the sliding groove. A rotation axis of the rotating member extends in a second direction, where the second direction is separately perpendicular to the first direction and the height direction. The rotating member is configured to be in contact with a board, to cause the board to move in the sliding groove. In this application, rolling friction is formed between the board and the rotating member, so that abrasion on the board and the body is greatly reduced, thereby avoiding chipping caused by sliding friction. In addition, this structure further reduces motion resistance to the board, thereby greatly reducing insertion and removal force of the board, facilitating operations, and improving insertion and removal experience.

## Description

The present invention claims priority to Chinese Patent Application No. 202322284637.5, filed with the China National Intellectual Property Administration on August 23, 2023 and entitled "COMMUNICATION DEVICE SUBRACK AND COMMUNICATION DEVICE", which is incorporated herein by reference in its entirety.

### TECHNICAL FIELD

This application relates to the field of communication technologies, and in particular, to a communication device subrack and a communication device.

### BACKGROUND

As an integration degree of a board in a communication device becomes higher, the board develops toward a hardware layout with high density and heavy weight. However, when the board exceeds a weight, relative sliding friction between the board and a chassis may cause chipping in a process of inserting the board into the chassis. Metal chips may cause a safety accident on the device, and non-metal chips may affect cooperation between connectors inside the chassis, causing a fault.

### SUMMARY

An objective of this application is to provide a communication device subrack and a communication device, to resolve an existing problem of chipping in a process of inserting a board into a chassis.

A first aspect of this application provides a communication device subrack. The subrack includes a body and a rotating member. A sliding groove extending in a first direction is disposed on the body, where the first direction is perpendicular to a height direction of the communication device subrack. The rotating member is rotatably disposed on the body and at least partially located in the sliding groove. A rotation axis of the rotating member extends in a second direction, where the second direction is separately perpendicular to the first direction and the height direction. The rotating member is configured to be in contact with a board, to cause the board to move in the sliding groove.

In this application, rolling friction is formed between the board and the rotating member, so that abrasion on the board and the body is greatly reduced, thereby avoiding chipping caused by sliding friction. In addition, this structure further reduces motion resistance to the board, thereby greatly reducing insertion and removal force of the board, facilitating operations, and improving insertion and removal experience.

In a possible design, the rotating member is a needle roller. In an insertion process of the board, the needle roller may rotate through rolling friction force between the needle roller and the board, to prevent the board from being subject to large friction and causing chipping. In addition, the motion resistance to the board is reduced, the insertion and removal force of the board is reduced, and the insertion and removal experience is improved.

In a possible design, the body includes a first bottom plate and a plurality of guiding convex ribs. The guiding convex rib is connected to the first bottom plate, and the guiding convex rib protrudes from a surface of the first bottom plate. The sliding groove is formed between the first bottom plate and at least two adjacent guiding convex ribs. The needle roller is rotatably disposed on the first bottom plate. The needle roller at least partially protrudes from the surface of the first bottom plate. In a process of inserting and removing the board, the board may be in contact with a part that is of the needle roller and that protrudes from the first bottom plate, but may not be in contact with the first bottom plate, so that friction between the board and the body in the process of inserting and removing the board is reduced through rolling of the needle roller, and chipping is avoided.

In a possible design, a first through hole is provided on the first bottom plate, and the needle roller is rotatably disposed in the first through hole. The needle roller at least partially extends out of the first through hole toward a side of the guiding convex rib, and in the height direction of the communication device subrack, projections of two ends of the needle roller at least partially overlap projections of the corresponding guiding convex ribs respectively. A length of the needle roller is greater than a distance between the two adjacent guiding convex ribs forming the sliding groove. After the needle roller is mounted in the first through hole, the guiding convex ribs on two sides of the sliding groove may block the two ends of the needle roller, so that the needle roller can be limited in the height direction of the subrack, and it is ensured that the needle roller can stably rotate in the first through hole.

In a possible design, the communication device subrack further includes a limiting member connected to the body. The limiting member at least partially blocks, in the height direction of the communication device subrack, a side that is of the first through hole and that is away from the guiding convex rib. The limiting member is used to block the side that is of the first through hole and that is away from the guiding convex rib, so that the needle roller can be limited between the limiting member and the guiding convex rib. Therefore, it can be ensured that the needle roller stably rotates in the first through hole.

In a possible design, a groove is disposed on one end that is of the guiding convex rib and that is connected to the first bottom plate. The groove is in communication with the first through hole in the second direction. The two ends of the needle roller are rotatably disposed in grooves on the corresponding guiding convex ribs respectively, so that a position of the needle roller in the first through hole is closer to the side of the guiding convex rib, to help enable the needle roller to at least partially extend out of a side that is of the first through hole and that is close to the guiding convex rib.

In a possible design, a hollowed portion is disposed on the body. The hollowed portion is disposed between two adjacent sliding grooves. The disposition of the hollowed portion reduces an overall weight of the subrack, and facilitates implementation of a lightweight design. In addition, the hollowed portion also facilitates a part of the limiting member to extend into the hollowed portion, and to block the two ends of the needle roller in the second direction, so as to prevent the needle roller from moving, thereby ensuring that the needle roller can stably rotate in the first through hole.

In a possible design, the limiting member includes a second bottom plate, a first baffle, and a second baffle. The first baffle and the second baffle are respectively connected to two ends of the second bottom plate. The second bottom plate is connected to the first bottom plate. The first baffle extends into the hollowed portion on one side of the sliding groove and blocks one end that is of the needle roller and that is in the second direction. The second baffle extends into the hollowed portion on the other side of the sliding groove and blocks the other end that is of the needle roller and that is in the second direction. The second bottom plate may limit the needle roller in the first through hole by cooperating with the guiding convex rib, to prevent the needle roller from moving in the height direction of the subrack. The first baffle and the second baffle may block the two sides of the needle roller respectively, to prevent the needle roller from moving in the second direction. In this way, the second bottom plate, the first baffle, and the second baffle can ensure that the needle roller can stably rotate in the first through hole.

In a possible design, the rotating member is a ball roller.

In a possible design, the communication device subrack further includes a first support frame. The first support frame is connected to the body, a gap exists between the first support frame and a bottom surface of the body, and the ball roller is rotatably disposed in the gap. A second through hole is provided on the body. A diameter of the second through hole is less than a diameter of the ball roller. The ball roller at least partially extends out of the second through hole. The first support frame and the body may both be of a plate structure with a uniform thickness. The body is located on a side that is of the first support frame and that is close to the board, and a gap can be maintained between the bottom surface of the body and the first support frame, to cause the ball roller to be rotatably embedded in the gap. In addition, because the diameter of the second through hole on the body is less than a maximum diameter of the ball roller, the ball roller can partially extend out of the second through hole to be in contact with the board, and the ball roller can be limited to ensure that the ball roller can stably rotate in the second through hole.

In a possible design, a flange is disposed at an edge of the second through hole. The flange protrudes from a surface that is of the body and that is away from the first support frame, and the ball roller at least partially protrudes from an end face of the flange. The flange can improve structural strength around the second through hole, and improve a limiting effect on the ball roller, to ensure that the ball roller stably rotates in the second through hole.

In a possible design, the first support frame includes a mounting plate and a support plate. The mounting plate is connected to the support plate and is configured to connect to an inner side wall of a chassis body of a communication device. The gap exists between the body and the support plate. The support plate has a large length in the first direction, and has a width in the second direction, so that the board can be stably supported above the support plate. The mounting plate and the support plate may be bent to form an angle, so that the mounting plate is attached to and fixed on the inner side wall of the chassis body.

In a possible design, the communication device subrack further includes a second support frame. The second support frame is connected to the body. A mounting hole is provided on the body. An inner diameter of the mounting hole gradually decreases from a side close to the second support frame to a side away from the second support frame in the height direction of the communication device subrack. An inner diameter that is of the mounting hole and that is on the side close to the second support frame is greater than a diameter of the ball roller, and an inner diameter that is of the mounting hole and that is on the side away from the second support frame is less than the diameter of the ball roller, so that the ball roller can at least partially extend out of the side that is of the mounting hole and that is away from the second support frame. The mounting hole forms a similar tapered hole, and an end with a larger diameter of the mounting hole facilitates mounting the ball roller into the mounting hole. An end with a smaller diameter of the mounting hole can limit the ball roller to prevent the ball roller from dropping, and the ball roller can at least partially protrude from the end with a smaller diameter of the mounting hole to be in contact with the board.

In a possible design, a plurality of rotating members are disposed. At least a part of the rotating members have different sizes in the height direction of the communication device subrack. The rotating members with the different sizes in the height direction are used in combination, so that the rotating members with the different sizes can adapt to a non-flat surface on the board, and it is ensured that each position corresponding to the rotating member on a surface that is of the board and that is used to cooperate with the rotating member is in contact with the corresponding rotating member in the insertion process of the board and after the insertion is completed, thereby ensuring stability in the insertion process of the board and after the insertion is completed.

In a possible design, the sliding groove includes a first support area and a second support area in the first direction. The first support area is closer to an entrance side of the sliding groove than the second support area. The plurality of rotating members are disposed. In the first direction, a distance between two adjacent rotating members in the first support area is less than a distance between two adjacent rotating members in the second support area. The first support area and the second support area represent region ranges on the sliding groove, and the rotating member may be disposed within the region ranges. A distribution density of the rotating member in the first support area is higher than a distribution density of the rotating member in the second support area. In other words, in a same area of the first support area and the second support area, the distribution density of the rotating member in the first support area is relatively higher. When the board begins to be inserted into the chassis body, the board is preferentially in contact with the rotating member in the first support area. In this case, the rotating member in the first support area is under a relatively larger pressure. Therefore, the distribution density of the rotating member in the first support area is relatively higher, so that reliable support is provided for the board beginning to be inserted into the chassis body, to ensure the stability in the insertion process of the board. When the board is in contact with the rotating member in the second support area, the board may be jointly supported by the rotating members in both the first support area and the second support area. In this way, stability of supporting the board can be ensured in the entire insertion process of the board.

In a possible design, the communication device subrack further includes a guiding member. The guiding member is connected to the body. The guiding member is aligned with the sliding groove in the first direction. The guiding member is disposed on the entrance side of the sliding groove. An inclined plane is disposed on the guiding member, and the board may slide into the sliding groove through the inclined plane on the guiding member at a beginning of the insertion process, thereby preventing the board from being stuck in the insertion process, and facilitating an insertion operation.

In a possible design, the communication device subrack further includes the chassis body, and the body is disposed in the chassis body. The chassis body has space, so that the board, a back plate, and the body can all be mounted in the chassis body. The chassis body may provide protection for the board, the back plate, and the body.

In a possible design, a plurality of bodies are disposed. The plurality of bodies are symmetrically disposed on an inner wall at the top of the chassis body and an inner wall at the bottom of the chassis body. The board can be inserted into the chassis body in a vertical posture. The top of the board can cooperate with a sliding groove on the body on the inner wall at the top of the chassis body, and a bottom of the board can cooperate with a sliding groove on the body on the inner wall at the bottom of the chassis body. Through a guiding function of the sliding groove on the body at the top of the chassis body and the sliding groove on the body at the bottom of the chassis body, it can be ensured that the board is stably and accurately inserted into the chassis body in the vertical posture.

In a possible design, a plurality of bodies are disposed. The plurality of bodies are symmetrically disposed on inner walls of two opposite side walls of the chassis body. The board can be inserted into the chassis body in a horizontal posture. Two ends that are of the board and that are in a lateral direction can respectively cooperate with corresponding sliding grooves on the body on the side wall of the chassis body, so that the board can be mounted in the horizontal posture.

A second aspect of this application further provides a communication device, including a board and the communication device subrack provided in the first aspect of this application. The board is mounted in a sliding groove of the communication device subrack and is supported on a rotating member. The communication device including the subrack has a technical effect similar to that of the foregoing subrack, and details are not described herein again.

It should be understood that the foregoing general descriptions and the following detailed descriptions are merely examples, and do not limit this application.

### BRIEF DESCRIPTION OF DRAWINGS

FIG. 1 is a schematic diagram of a structure of a communication device according to an embodiment of this application;
FIG. 2 is a schematic diagram of a structure of a communication device subrack according to an embodiment of this application;
FIG. 3 is a schematic diagram of a structure of a communication device according to another embodiment of this application;
FIG. 4 is a schematic diagram of a structure of a communication device subrack according to another embodiment of this application;
FIG. 5 is a schematic partial diagram of a structure of a communication device subrack according to a first embodiment of this application;
FIG. 6 is a schematic partial diagram of a structure of a communication device subrack according to a second embodiment of this application;
FIG. 7 is a schematic diagram of a structure of a body in a communication device subrack according to an embodiment of this application;
FIG. 8 is an enlarged view of a location A in FIG. 7;
FIG. 9 is an enlarged view of a location B in FIG. 5;
FIG. 10 is a schematic diagram of a structure of a limiting member according to an embodiment of this application;
FIG. 11 is a partial cross-sectional view of FIG. 6;
FIG. 12 is a schematic partial diagram of a structure of a communication device subrack according to a third embodiment of this application;
FIG. 13 is a partial cross-sectional view of the communication device subrack shown in FIG. 12;
FIG. 14 is a schematic partial diagram of a structure of a communication device subrack according to a fourth embodiment of this application;
FIG. 15 is a partial cross-sectional view of the communication device subrack shown in FIG. 14;
FIG. 16 is an enlarged view of location C in FIG. 15;
FIG. 17 is a schematic partial diagram of a structure of a communication device subrack according to a fifth embodiment of this application;
FIG. 18 is a partial cross-sectional view of the communication device subrack shown in FIG. 17; and
FIG. 19 is a schematic diagram in which a board cooperates with a rotating member according to an embodiment of this application.

### Reference numerals:

1-body;
   11-sliding groove;
      111-first support area;
      112-second support area;
   12-guiding convex rib;
      121-groove;
   13-first bottom plate;
   131-first through hole;
   14-hollowed portion;
   15-second through hole;
      151-flange;
   16-mounting hole;
2-rotating member;
   21-needle roller;
   22-ball roller;
3-limiting member;
   31-second bottom plate;
   32-first baffle;
   33-second baffle;
4a-first support frame;
   4a1-mounting plate;
   4a2-support plate;
4b-second support frame;
5-guiding member;
   51-inclined plane;
10-communication device subrack;
100-chassis body;
200-board;
a-gap;
X-first direction;
Y-second direction; and
Z-height direction.

The accompanying drawings herein are incorporated into this specification and constitute a part of this specification, show embodiments conforming to this application, and are used, together with this specification, to explain the principle of this application.

### DESCRIPTION OF EMBODIMENTS

To better understand technical solutions of this application, the following describes embodiments of this application in detail with reference to the accompanying drawings. It should be understood that the specific embodiments described herein are merely used to explain this application but are not intended to limit this application.

In the descriptions of this application, unless otherwise explicitly specified or defined, the terms "first" and "second" are merely used for a purpose of description, and shall not be understood as an indication or implication of relative importance. Unless otherwise specified or explained, the term "a plurality of" refers to two or more. The terms "connection", "fixed", and the like should be understood in a broad sense. For example, the "connection" may be a fixed connection, or may be a detachable connection, an integrated connection, or an electrical connection; or the "connection" may be a direct connection, or an indirect connection through an intermediary. A person of ordinary skill in the art may understand specific meanings of the foregoing terms in this application based on specific situations.

In a subrack-shaped network communication device, a board 200 usually needs to be mounted in a chassis along a sliding rail in the chassis, to be connected to a back plate in the chassis, so as to implement signal interconnection between different boards 200. For example, a circuit board is disposed on the board 200, a pinhole slot connected to the circuit board is disposed at an edge of the board 200, and a pin is disposed on the back plate. The board 200 may be plugged into the pin on the back plate through a structure such as a slot or a connector on the board 200, to implement signal interconnection.

However, as an integration degree of the board 200 in the communication device becomes higher, the board 200 develops toward a hardware layout with a high density and an excessively large weight. When the board 200 exceeds a weight, relative sliding friction between the board 200 and the chassis may cause chipping in a process of inserting the board into the chassis. A metal chip may cause a regulatory accident, and a nonmetal chip may affect cooperation between connectors inside the chassis and consequently cause a fault. In addition, sliding friction usually exists between a conventional board and the sliding rail in the chassis. As a result, large insertion and removal force is required to insert and remove the board 200, and it is inconvenient for an insertion and removal operation of the board 200. For example, when the board 200 is inserted into the chassis, if excessively large force is used, the board 200 is likely to be inclined. As a result, a cooperation error between the board 200 and the back plate is caused, quick and accurate insertion is hard to be implemented, and a problem of inverted pin is also caused.

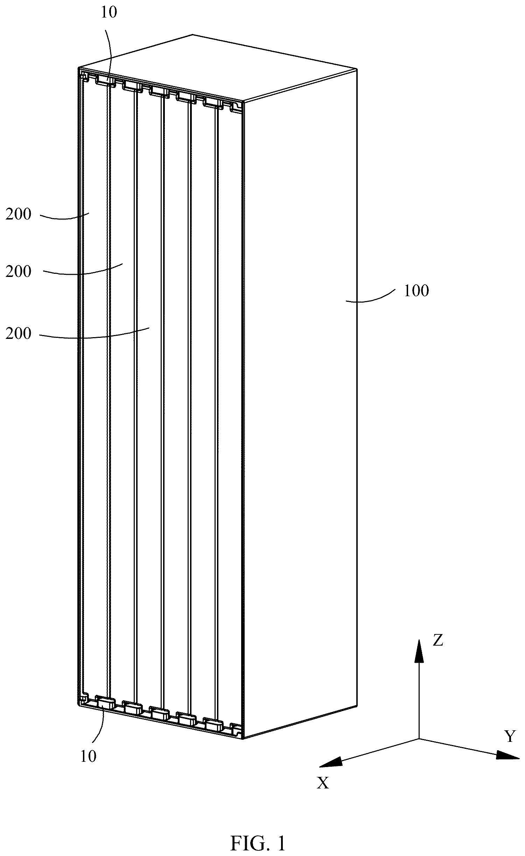

Embodiments of this application provide a communication device subrack 10 (referred to as a subrack 10 for short below). The subrack 10 is used in a communication device. FIG. 1 is a schematic diagram of a structure of a communication device according to an embodiment of this application. FIG. 1 merely shows an example in which the communication device is a server. Certainly, in some other embodiments, the communication device may alternatively be an optical network device, a data communication device, a storage device, or the like. A specific type of the communication device is not limited in this embodiment. A back plate may be mounted in the subrack 10, and the subrack 10 further has space for mounting the board 200. One or more boards 200 can be mounted in the subrack 10 and can be inserted into a corresponding position on the back plate.

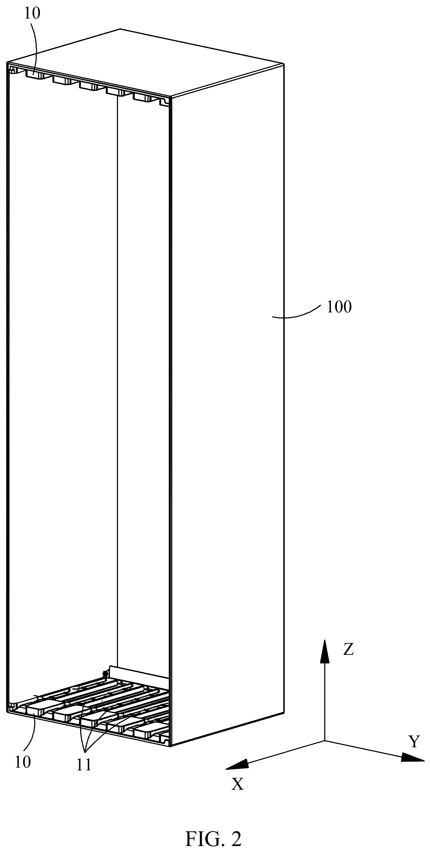

FIG. 2 is a schematic diagram of a structure of a communication device subrack 10 according to an embodiment of this application. As shown in FIG. 2, the subrack 10 provided in this embodiment of this application includes a body 1. A sliding groove 11 is disposed on the body 1. The sliding groove 11 extends in a first direction X, and the first direction X is perpendicular to a height direction Z of the communication device subrack 10. In an embodiment, the subrack 10 further includes a chassis body 100. The chassis body 100 is used as a housing component of the subrack 10, and the chassis body 100 has space, so that a board 200, a back plate, and the body 1 may all be mounted in the chassis body 100. The chassis body 100 may provide protection for the board 200, the back plate, and the body 1. For example, the back plate may be disposed on an inner wall of a first side of the chassis body 100. A second side of the chassis body 100 is a non-closed side, to facilitate the board 200 being inserted into the subrack 10. The first side and the second side of the chassis body 100 are two opposite sides in the first direction X, and the sliding groove 11 extends from the second side to the first side.

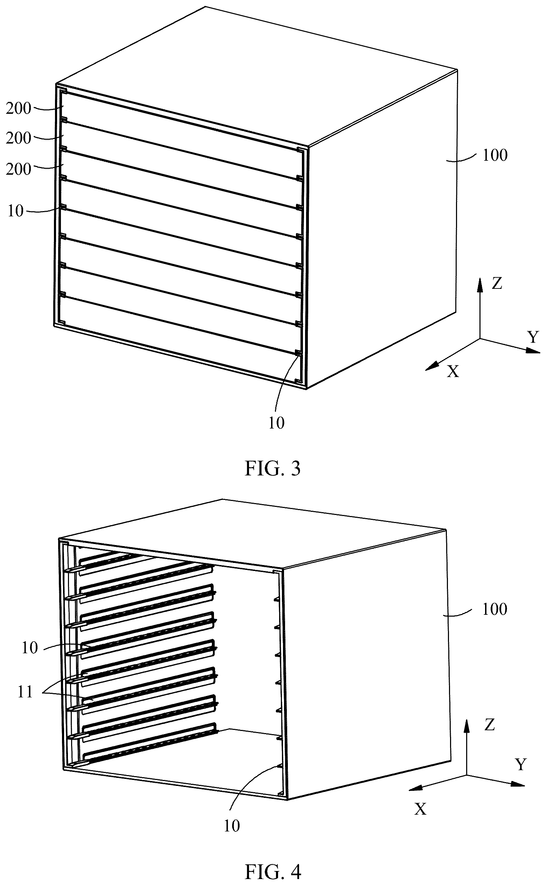

The subrack 10 may have two types: a vertically inserted type and a horizontally inserted type. As shown in FIG. 2, for the vertically inserted subrack 10, the bodies 1 are symmetrically disposed on an inner wall at the top of the chassis body 100 and an inner wall at the bottom of the chassis body 100. As shown in FIG. 1, the board 200 can be inserted into the chassis body 100 in a vertical posture. The top of the board 200 can cooperate with a sliding groove 11 on the body 1 on the inner wall at the top of the chassis body 100, and a bottom of the board 200 can cooperate with a sliding groove 11 on the body 1 on the inner wall at the bottom of the chassis body 100. Through a guiding function of the sliding groove 11 on the body 1 at the top of the chassis body 100 and the sliding groove 11 on the body 1 at the bottom of the chassis body 100, it can be ensured that the board 200 is stably and accurately inserted into the chassis body 100 in the vertical posture. In addition, FIG. 3 is a schematic diagram of a structure of a communication device according to another embodiment of this application. FIG. 4 is a schematic diagram of a structure of a communication device subrack 10 according to another embodiment of this application. As shown in FIG. 4, for the horizontally inserted subrack 10, the bodies 1 are symmetrically disposed on inner walls of two opposite side walls of the chassis body 100. As shown in FIG. 3, the board 200 can be inserted into the chassis body 100 in a horizontal posture. Two ends that are of the board 200 and that are in a lateral direction can respectively cooperate with corresponding sliding grooves 11 on the body 1 on the side wall of the chassis body 100, so that the board 200 can be mounted in the horizontal posture. In this way, mounting positions of the body 1 in the chassis body 100 are different, so that the board 200 can have different mounting postures, to satisfy different mounting requirement scenarios of the board 200 and the subrack 10.

In an embodiment, the body 1 and the chassis body 100 are two independent structural components. The body 1 may be fixed on the chassis body 100 by using a connecting member such as a screw or a rivet, to facilitate disassembly and replacement, and facilitate adjustment of a mounting position of the body 1, so as to adapt to different mounting requirements on the board 200 in different mounting scenarios.

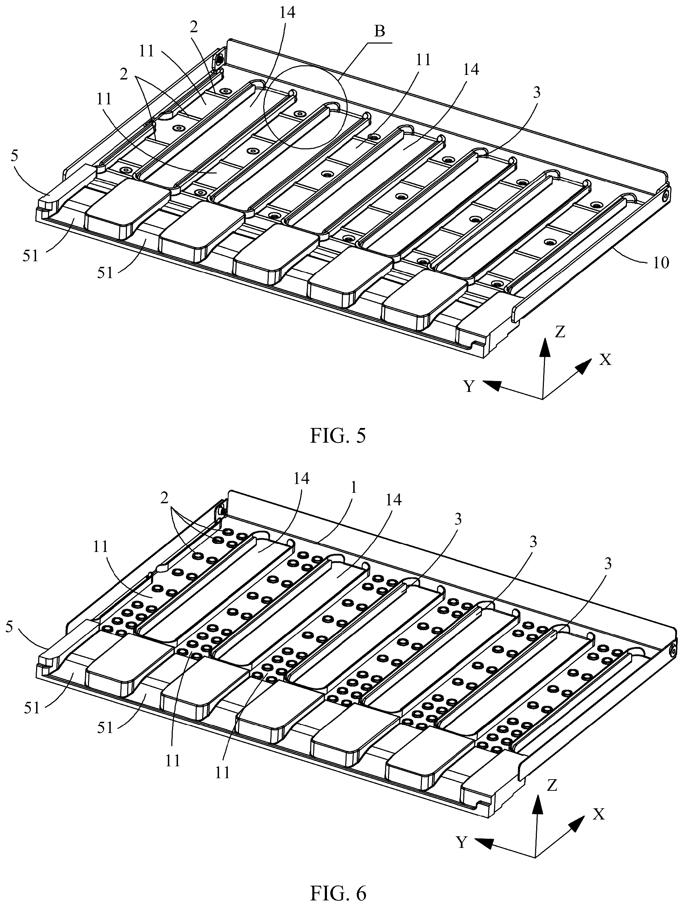

FIG. 5 is a schematic partial diagram of a structure of a communication device subrack 10 according to a first embodiment of this application. FIG. 6 is a schematic partial diagram of a structure of a slide-guiding apparatus communication device subrack 10 according to a second embodiment of this application. As shown in FIG. 5 or FIG. 6, the subrack 10 further includes a rotating member 2. The rotating member 2 is rotatably disposed on the body 1, and the rotating member 2 at least partially locates in the sliding groove 11. A rotation axis of the rotating member 2 extends in a second direction Y, where the second direction Y is separately perpendicular to the foregoing first direction X and height direction Z of the communication device subrack 10. The rotating member 2 is configured to be in contact with the board 200, to cause the board 200 to move in the sliding groove 11.

As shown in FIG. 5, the rotating member 2 may be a needle roller 21. As shown in FIG. 6, the rotating member 2 may alternatively be a ball roller 22. As shown in FIG. 5, the needle roller 21 is an elongated cylinder. An axis extension direction of the needle roller 21 is consistent with the foregoing second direction Y. As shown in FIG. 6, the ball roller 22 is sphered or ellipsoidal. A sphered ball roller 22 has equal diameters in all directions, and directivity of the sphered ball roller 22 may not be considered when the sphered ball roller 22 is disposed. An ellipsoidal ball roller 22 has a major diameter and a minor diameter, and a direction of the major diameter is consistent with the second direction Y.

When the board 200 is inserted into the chassis body 100, at least a bottom surface of the board 200 may be in contact with the rotating member 2. As the board 200 is pushed into the chassis body 100, friction force between the board 200 and the rotating member 2 may drive the rotating member 2 to rotate, that is, rolling friction is formed between the board 200 and the rotating member 2. Abrasion on the board 200 and the body 1 is greatly lower than conventional sliding friction between the board 200 and a sliding rail in the chassis, thereby avoiding chipping caused by the sliding friction. In addition, this structure further reduces motion resistance to the board 200, thereby greatly reducing insertion and removal force of the board 200, facilitating operations, and improving insertion and removal experience.

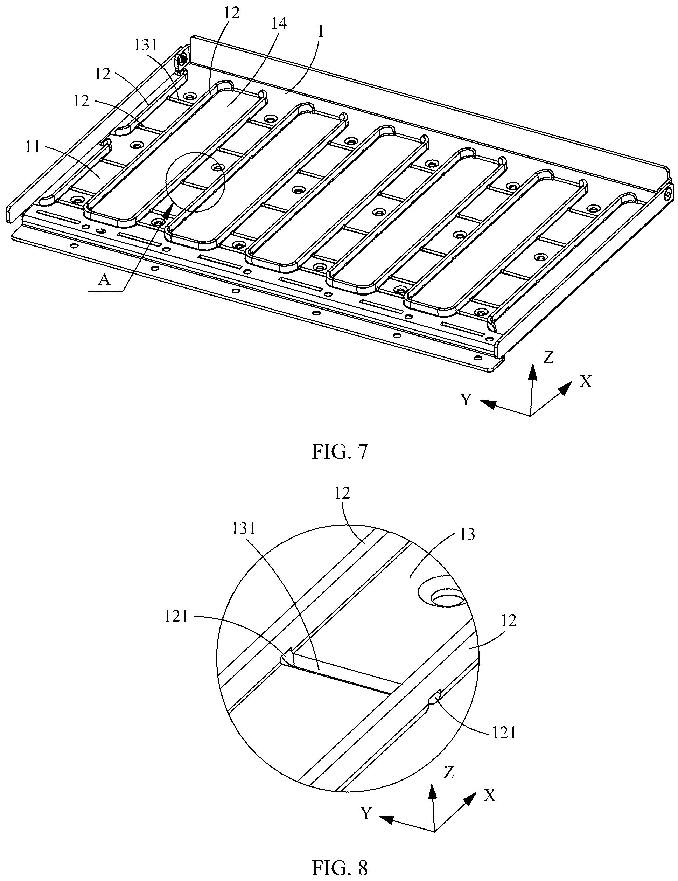

In an embodiment, FIG. 7 is a schematic diagram of a structure of a body 1 in a communication device subrack 10 according to an embodiment of this application. As shown in FIG. 7, the rotating member 2 may be the needle roller 21. The body 1 includes a first bottom plate 13 and a plurality of guiding convex ribs 12. The guiding convex rib 12 is connected to the first bottom plate 13, and the guiding convex rib 12 protrudes from a surface of the first bottom plate 13. The sliding groove 11 is formed between the first bottom plate 13 and at least two adjacent guiding convex ribs 12. The needle roller 21 is rotatably disposed on the first bottom plate 13, and the needle roller 21 at least partially protrudes from the surface of the first bottom plate 13. In a process of inserting and removing the board 200, the board 200 may be in contact with a part that is of the needle roller 21 and that protrudes from the first bottom plate 13, but may not be in contact with the first bottom plate 13, so that friction between the board 200 and the body 1 in the process of inserting and removing the board 200 is reduced through rolling of the needle roller 21, and chipping is avoided.

A length direction of the guiding convex rib 12 is consistent with the first direction X. The plurality of guiding convex ribs 12 are all located on a same side of the first bottom plate 13. A distance exists between two adjacent guiding convex ribs 12, and the guiding convex ribs 12 can cooperate with the first bottom plate 13 to form the sliding groove 11 for sliding the board 200. The distance between the two adjacent guiding convex ribs 12 may be slightly greater than a thickness of the board 200, to cause the board 200 to slide between the two adjacent guiding convex ribs 12. In an embodiment, the guiding convex rib 12 and the first bottom plate 13 may be integrally formed. To be specific, in a forming process of the body 1, the first bottom plate 13 and each guiding convex rib 12 may be integrally formed, thereby ensuring structural reliability and improving structural strength. In an embodiment, there may be a plurality of sliding grooves 11 formed by the first bottom plate 13 and the guiding convex rib 12, and the sliding grooves 11 are parallel to each other, so that an insertion and removal of a plurality of boards 200 can be implemented.

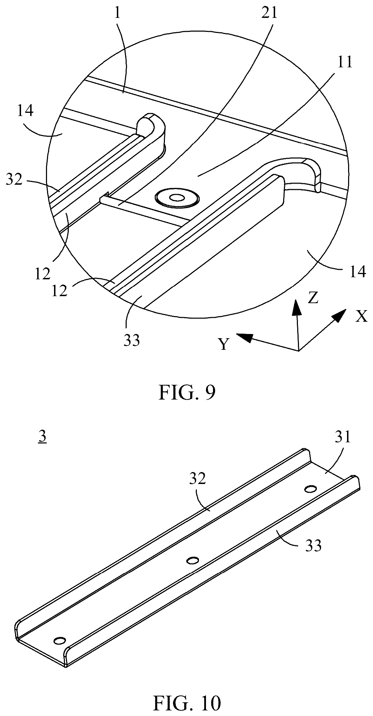

In an embodiment, FIG. 8 is an enlarged view of a location A in FIG. 7. As shown in FIG. 8, a first through hole 131 is provided on the first bottom plate 13. FIG. 9 is an enlarged view of a location B in FIG. 5. As shown in FIG. 9, the needle roller 21 is rotatably disposed in the first through hole 131. The needle roller 21 at least partially extends out of the first through hole 131 toward a side of the guiding convex rib 12, and in the height direction Z of the communication device subrack 10, projections of two ends of the needle roller 21 at least partially overlap projections of the corresponding guiding convex ribs 12 respectively. A length of the needle roller 21 is greater than the distance between the two adjacent guiding convex ribs 12 forming the sliding groove 11. After the needle roller 21 is mounted in the first through hole 131, the guiding convex ribs 12 on two sides of the sliding groove 11 may block the two ends of the needle roller 21 respectively, so that the needle roller 21 can be limited in the height direction Z of the subrack 10, and it is ensured that the needle roller 21 can stably rotate in the first through hole 131.

In an embodiment, as shown in FIG. 9, the subrack 10 further includes a limiting member 3. The limiting member 3 is connected to the body 1, and the limiting member 3 at least partially blocks, in the height direction Z of the communication device subrack 10, a side that is of the through hole and that is away from the guiding convex rib 12.

The needle roller 21 may be mounted in the first through hole 131 from a side that is of the first through hole 131 and that is away from the guiding convex rib 12. Because the length of the needle roller 21 is greater than the distance between the guiding convex ribs 12 on the two sides of the sliding groove 11, two ends of the needle roller 21 may be blocked by the corresponding guiding convex ribs 12. The needle roller 21 may be prevented, through limiting from the guiding convex ribs 12, from dropping from the first through hole 131. Then, the limiting member 3 may be mounted on the body 1. Optionally, the limiting member 3 may be mounted on the body 1 by using a screw, a rivet, a buckle, or the like. The limiting member 3 may block the side that is of the first through hole 131 and that is away from the guiding convex rib 12. In this way, the needle roller 21 can be limited between the limiting member 3 and the guiding convex rib 12, so that it can be ensured that the needle roller 21 stably rotates in the first through hole 131.

To prevent the needle roller 21 from moving in the second direction Y, the limiting member 3 at least partially may block the two ends of the needle roller 21 in the second direction Y, so that it can be ensured that the needle roller 21 stably rotates in the first through hole 131.

In an embodiment, as shown in FIG. 8, a groove 121 is disposed on one end of that is of the guiding convex rib 12 and that is connected to the first bottom plate 13. The groove 121 is in communication with the first through hole 131 in the second direction Y. The two ends of the needle roller 21 are rotatably disposed in grooves 121 on the corresponding guiding convex ribs 12 respectively. In this way, a position of the needle roller 21 in the first through hole 131 is closer to a side of the guiding convex rib 12, to cause the needle roller 21 to at least partially extend out of a side that is of the first through hole 131 and that is close to the guiding convex rib 12.

In an embodiment, as shown in FIG. 5, a hollowed portion 14 is disposed on the body 1, and is disposed between two adjacent sliding grooves 11. The hollowed portion 14 reduces an overall weight of the subrack 10, and facilitates implementation of a lightweight design. In addition, the hollowed portion 14 also facilitates a part of the limiting member 3 to extend into the hollowed portion 14, and to block the two ends of the needle roller 21 in the second direction Y, so as to prevent the needle roller 21 from moving, thereby ensuring that the needle roller 21 can stably rotate in the first through hole 131.

In an embodiment, FIG. 10 is a schematic diagram of a structure of a limiting member 3 according to an embodiment of this application. As shown in FIG. 10, the limiting member 3 includes a second bottom plate 31, a first baffle 32, and a second baffle 33. The first baffle 32 and the second baffle 33 are respectively connected to two ends of the second bottom plate 31. The second bottom plate 31 is connected to the first bottom plate 13. The first baffle 32 extends into the hollowed portion 14 on one side of the sliding groove 11, and blocks one end of the needle roller 21 in the second direction Y. The second baffle 33 extends into the hollowed portion 14 on the other side of the sliding groove 11, and blocks the other end of the needle roller 21 in the second direction Y.

The second bottom plate 31 may limit the needle roller 21 in the first through hole 131 by cooperating with the guiding convex rib 12, to prevent the needle roller 21 from moving in the height direction Z of the subrack 10. The first baffle 32 and the second baffle 33 may block the two sides of the needle roller 21 respectively, to prevent the needle roller 21 from moving in the second direction Y. In this way, the second bottom plate 31, the first baffle 32, and the second baffle 33 can ensure that the needle roller 21 can stably rotate in the first through hole 131.

In an embodiment, the limiting member 3 is an integrally formed structure. To be specific, in a forming process of the limiting member 3, the second bottom plate 31, the first baffle 32, and the second baffle 33 can be integrally formed. In this way, structural strength of the limiting member 3 is improved, and reliability of mounting the limiting member 3 on the body 1 is improved.

In an embodiment, the rotating member 2 may be a ball roller 22. As described above, the ball roller 22 may be sphered or ellipsoidal. A sphered ball roller 22 has equal diameters in all directions, and directivity of the sphered ball roller 22 may not be considered when the sphered ball roller 22 is disposed. An ellipsoidal ball roller 22 has a major diameter and a minor diameter, and a direction of the major diameter is consistent with the second direction Y during mounting.

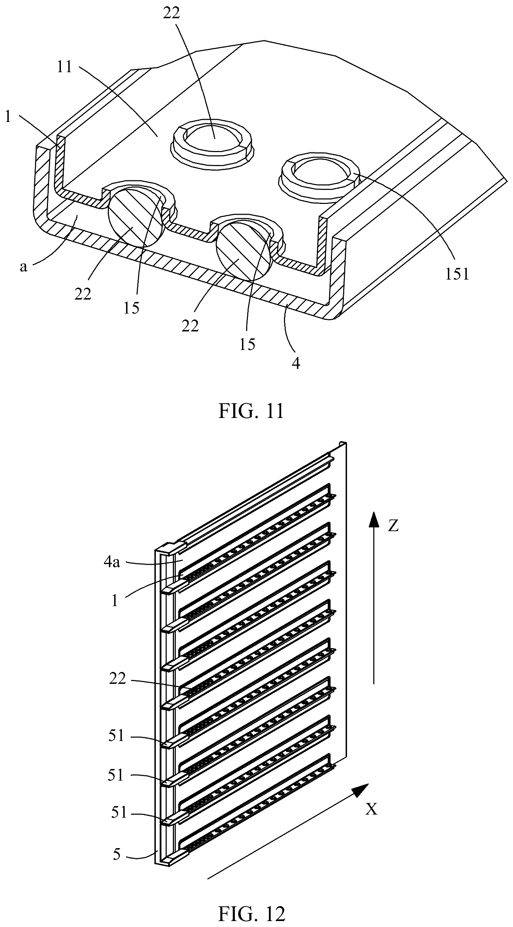

The ball roller 22 may be applied to the vertically inserted subrack 10 shown in FIG. 2, or may be applied to the horizontally inserted subrack 10 shown in FIG. 4. In an embodiment, an example in which the ball roller 22 is applied to the vertically inserted subrack 10 shown in FIG. 2 is used for description. FIG. 11 is a partial cross-sectional view of FIG. 6. As shown in FIG. 11, the communication device subrack 10 further includes a first support frame 4a, the first support frame 4a is connected to the body 1, a gap a exists between the first support frame 4a and a bottom surface of the body 1, and the ball roller 22 is rotatably disposed in the gap a. A second through hole 15 is disposed on the body 1, a diameter of the second through hole 15 is less than a diameter of the ball roller 22, and the ball roller 22 at least partially extends out of the second through hole 15.

The first support frame 4a and the body 1 may both be of a plate structure with a uniform thickness. The body 1 is located on a side that is of the first support frame 4a and that is close to the board 200. A gap a can be maintained between the bottom surface of the body 1 and the first support frame 4a, to cause the ball roller 22 to be rotatably embedded in the gap a. In addition, because the diameter of the second through hole 15 on the body 1 is less than a maximum diameter of the ball roller 22, the ball roller 22 can partially extend out of the second through hole 15 to be in contact with the board 200, and the ball roller 22 can be limited to ensure that the ball roller 22 can stably rotate in the second through hole 15.

In an embodiment, the first support frame 4a may be mounted on the chassis body 100 by using a screw, a rivet, a buckle, or the like, to facilitate assembly. In an embodiment, the first support frame 4a and the chassis body 100 may alternatively be an integrally formed structure, that is, the first support frame 4a is a part structure of the chassis body 100, so that structural reliability and compactness are improved, internal space of the subrack 10 is saved, and implementation of miniaturization is facilitated.

In an embodiment, as shown in FIG. 11, a flange 151 is disposed at an edge of the second through hole 15, and the flange 151 protrudes from a surface that is of the body 1 and that is away from the first support frame 4a. The ball roller 22 at least partially protrudes from an end face of the flange 151. The flange 151 can improve structural strength around the second through hole 15, and can improve limiting effect on the ball roller 22, to ensure that the ball roller 22 stably rotates in the second through hole 15. In an embodiment, the flange 151 and the body 1 are an integrally formed structure. To be specific, in a process of manufacturing the body 1, the flange 151 may be simultaneously formed, thereby improving structural stability.

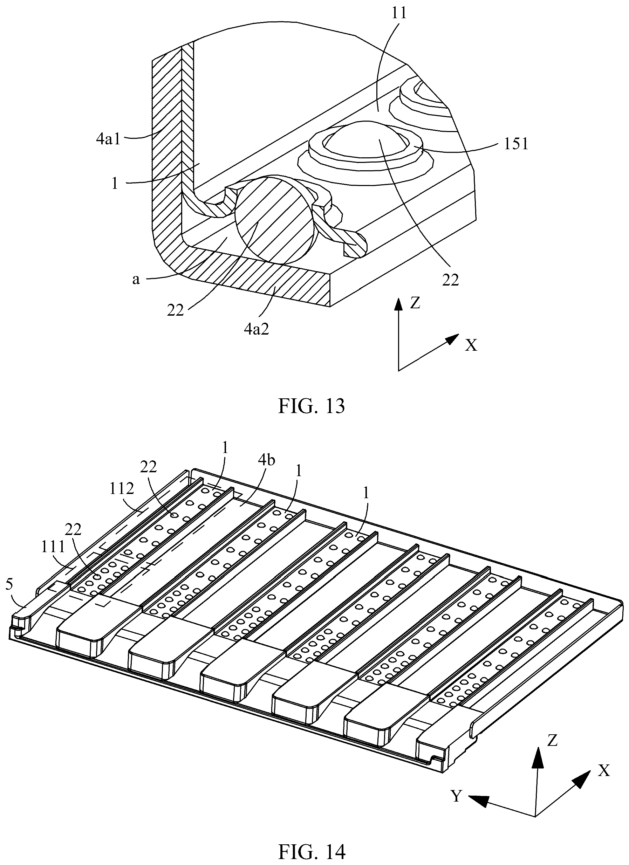

In an embodiment, FIG. 12 is a schematic partial diagram of a structure of a communication device subrack 10 according to a third embodiment of this application. FIG. 12 shows a partial structure of the horizontally inserted subrack 10. As shown in FIG. 12, the ball roller 22 may be applied to the horizontally inserted subrack 10. FIG. 13 is a partial cross-sectional view of the communication device subrack 10 shown in FIG. 12. As shown in FIG. 13, the first support frame 4a includes a mounting plate 4a1 and a support plate 4a2. The mounting plate 4a1 is connected to the support plate 4a2 and is configured to connect to an inner side wall of the chassis body 100 of the communication device, and the gap a exists between the body 1 and the support plate 4a2.

The support plate 4a2 has a large length in the first direction X, and has a width in the second direction Y, so that the board 200 can be stably supported above the support plate 4a2. In addition, the ball roller 22 may be disposed in the gap a between the support plate 4a2 and the body 1, and the ball roller 22 can at least partially protrude from an upper surface of the support plate 4a2, to be in contact with the board 200. The mounting plate 4a1 and the support plate 4a2 may be bent to form an angle, such as 90°, so that the mounting plate 4a1 is attached to and fixed on the inner side wall of the chassis body 100. In an embodiment, the first support frame 4a may be an integrally formed structure, to be specific, the mounting plate 4a1 and the support plate 4a2 may be simultaneously formed in a process of manufacturing the first support frame 4a. For example, the first support frame 4a may be an entire plate, which is bent, by using a bending craft or the like, into two parts that form an angle. The two parts are respectively used as the mounting plate 4a1 and the support plate 4a2, thereby improving structural strength of the first support frame 4a.

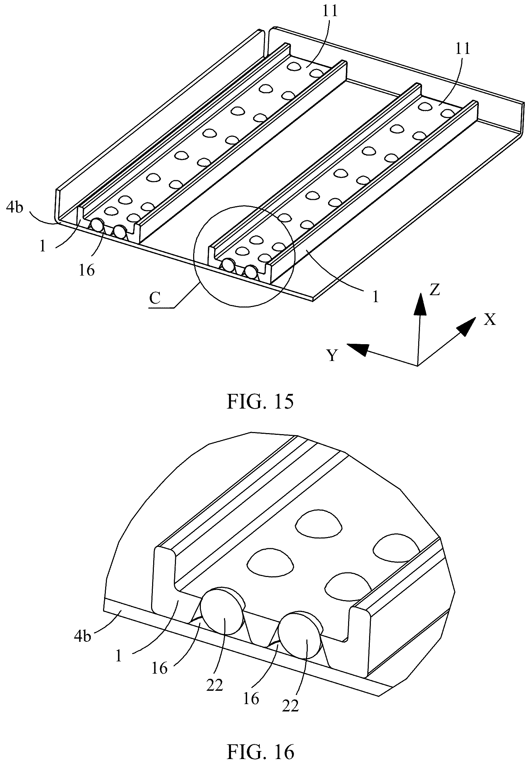

In an embodiment, FIG. 14 is a schematic partial diagram of a structure of a communication device subrack 10 according to a fourth embodiment of this application. The subrack 10 shown in FIG. 14 is a vertically inserted subrack 10. FIG. 15 is a partial cross-sectional view of the communication device subrack 10 shown in FIG. 14. FIG. 16 is an enlarged view of location C in FIG. 15. As shown in FIG. 14 to FIG. 16, the communication device subrack 10 further includes a second support frame 4b. The second support frame 4b is connected to the body 1, and a mounting hole 16 is provided on the body 1. An inner diameter of the mounting hole 16 gradually decreases from a side close to the second support frame 4b to a side away from the second support frame 4b in the height direction Z of the communication device subrack 10. An inner diameter that is of the mounting hole 16 and that is on the side close to the second support frame 4b is greater than a diameter of the ball roller 22, and an inner diameter that is of the mounting hole 16 and that is on the side away from the second support frame 4b is less than the diameter of the ball roller 22, so that the ball roller 22 can at least partially extend out of the side that is of the mounting hole 16 and that is away from the second support frame 4b. In other words, the mounting hole 16 forms a similar tapered hole. An end with a larger diameter of the mounting hole 16 facilitates mounting the ball roller 22 into the mounting hole 16. An end with a smaller diameter of the mounting hole 16 can limit the ball roller 22 to prevent the ball roller 22 from dropping, and the ball roller 22 can at least partially protrude from the end with a smaller diameter of the mounting hole 16 to be in contact with the board 200.

There are a plurality of bodies 1, and the sliding groove 11 is disposed on each body 1. Each body 1 may be fixedly mounted on the second support frame 4b by using a screw, a rivet, a buckle, or the like. In an assembly process, each ball roller 22 may be mounted into a corresponding mounting hole 16 from an end with a larger diameter of the mounting hole 16, and then the body 1 and the second support frame 4b are attached to, to cause the second support frame 4b to block the side with a larger diameter of the mounting hole 16, so as to prevent the ball roller 22 from dropping. Then, the body 1 and the second support frame 4b may be locked and fixed by using a connecting member such as a screw or a rivet, to ensure that the ball roller 22 stably rotates in the mounting hole 16.

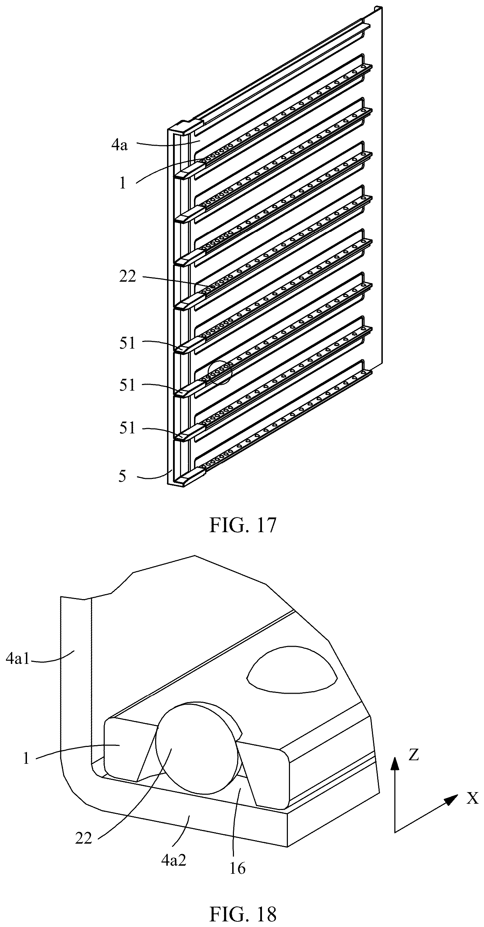

FIG. 17 is a schematic partial diagram of a structure of a communication device subrack 10 according to a fifth embodiment of this application. FIG. 18 is a partial cross-sectional view of the communication device subrack 10 shown in FIG. 17. The subrack 10 shown in FIG. 17 is a horizontally inserted subrack 10. The subrack 10 shown in FIG. 17 and FIG. 12 may use a first support frame 4a with a same structure. To be specific, the first support frame 4a includes the mounting plate 4a1 and the support plate 4a2, the mounting plate 4a1 is configured to connect to the chassis body 100, and the support plate 4a2 is configured to carry the board 200. A difference between the subrack 10 shown in FIG. 17 and the subrack 10 shown in FIG. 12 is that a structure of the body 1 is different. The body 1 in the subrack 10 shown in FIG. 17 may be mounted on the support plate 4a2 of the first support frame 4a, and a mounting hole 16 is provided on the body 1. A structure of the mounting hole 16 and a cooperation manner between the mounting hole 16 and the ball roller 22 are the same as those of the mounting hole 16 shown in FIG. 14 to FIG. 16, and details are not described herein again.

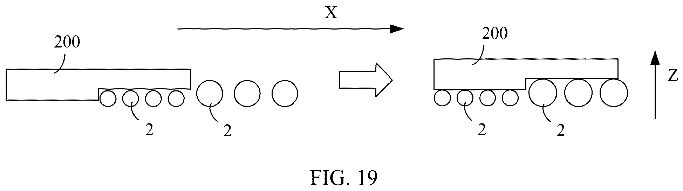

In an embodiment, FIG. 19 is a schematic diagram in which a board 200 cooperates with a rotating member 2 according to an embodiment of this application. As shown in FIG. 19, a plurality of rotating members 2 are disposed, and at least a part of the rotating members 2 have different sizes in the height direction Z of the communication device subrack 10. For example, for that the rotating member 2 is a needle roller 21, a size of the rotating member 2 in the height direction Z of the communication device subrack 10 is a diameter of the needle roller 21. For example, for that the rotating member 2 is a ball roller 22, when the ball roller 22 is sphered, a size of the rotating member 2 in the height direction Z of the communication device subrack 10 is a diameter of the sphered ball roller 22. When the ball roller 22 is ellipsoidal, a size of the rotating member 2 in the height direction Z of the communication device subrack 10 is the minor diameter of the ellipsoidal ball roller 22.

In an embodiment, a surface that is on the board 200 and that needs to be in contact with the rotating member 2 is a non-flat surface. If the rotating members 2 with a same dimension and specification are used, after the board 200 is mounted, a part of the surface that is of the board 200 and that is used to cooperate with the rotating member 2 can be in contact with the rotating member 2. However, because the surface is a non-flat surface, a distance exists between a part of the surface and the rotating member 2, and consequently, the board 200 cannot be stably supported, and the board 200 is easy to fall over. Therefore, in this embodiment, the rotating members 2 with different sizes in the height direction Z are used in combination, so that the rotating members 2 with the different size can adapt to a non-flat surface on the board 200, and it is ensured each position corresponding to the rotating member 2 on the surface that is of the board 200 and that is used to cooperate with the rotating member 2 is in contact with the corresponding rotating member 2 in the insertion process of the board 200 and after the insertion is completed, thereby ensuring stability in the insertion process of the board 200 and after the insertion is completed.

In an embodiment, as shown in FIG. 14, in the first direction X, the sliding groove 11 includes a first support area 111 and a second support area 112, and the first support area 111 is closer to an entrance side of the sliding groove 11 than the second support area 112. A plurality of rotating members 2 are disposed, and in the first direction X, a distance between two adjacent rotating members 2 in the first support area 111 is less than a distance between two adjacent rotating members 2 in the second support area 112. The first support area 111 and the second support area 112 represent region ranges on the sliding groove 11, and the rotating member 2 may be disposed within the region ranges. A distribution density of the rotating member 2 in the first support area 111 is higher than a distribution density of the rotating member 2 in the second support area 112. In other words, in a same area of the first support area 111 and the second support area 112, the distribution density of the rotating member 2 in the first support area 111 is relatively higher. When the board 200 begins to be inserted into the chassis body 100, the board 200 is preferentially in contact with the rotating member 2 in the first support area 111. In this case, the rotating member 2 in the first support area 111 is under a relatively larger pressure. Therefore, the distribution density of the rotating member 2 in the first support area 111 is relatively higher, so that reliable support is provided for the board 200 beginning to be inserted into the chassis body 100, to ensure the stability in the insertion process of the board 200. When the board 200 is in contact with the rotating member 2 in the second support area 112, the board 200 may be jointly supported by the rotating members 2 in both the first support area 111 and the second support area 112. In this way, stability of supporting the board 200 can be ensured in the entire insertion process of the board 200.

In an embodiment, as shown in FIG. 5, the communication device subrack 10 further includes a guiding member 5 connected to the body 1. The guiding member 5 is aligned with the sliding groove 11 in the first direction X. The guiding member 5 is disposed on an entrance side of the sliding groove 11. An inclined plane 51 is disposed on the guiding member 5, and the board 200 may slide into the sliding groove 11 through the inclined plane 51 on the guiding member 5 at a beginning of the insertion process, thereby preventing the board 200 from being stuck in the insertion process, and facilitating an insertion operation.

The foregoing descriptions are merely preferred embodiments of this application, and are not intended to limit this application. For a person skilled in the art, this application may have various modifications and variations. Any modification, equivalent replacement, or improvement made without departing from the spirit and principle of this application shall fall within the protection scope of this application.

## Claims

1. A communication device subrack, comprising:
a body (1), wherein a sliding groove (11) is disposed on the body (1), the sliding groove (11) extends in a first direction (X), and the first direction (X) is perpendicular to a height direction (Z) of the communication device subrack; and
a rotating member (2), wherein the rotating member (2) is rotatably disposed on the body (1) and at least partially located in the sliding groove (11), a rotation axis of the rotating member (2) extends in a second direction (Y), the second direction (Y) is separately perpendicular to the first direction (X) and the height direction (Z), and the rotating member (2) is configured to be in contact with a board (200), to cause the board (200) to move in the sliding groove (11).

2. The communication device subrack according to claim 1, wherein the rotating member (2) is a needle roller (21).

3. The communication device subrack according to claim 2, wherein the body (1) comprises a first bottom plate (13) and a plurality of guiding convex ribs (12), the guiding convex rib (12) is connected to the first bottom plate (13), the guiding convex rib (12) protrudes from a surface of the first bottom plate (13), and the sliding groove (11) is formed between the first bottom plate (13) and at least two adjacent guiding convex ribs (12); and
the needle roller (21) is rotatably disposed on the first bottom plate (13).

4. The communication device subrack according to claim 3, wherein a first through hole (131) is provided on the first bottom plate (13), the needle roller (21) is rotatably disposed in the first through hole (131), the needle roller (21) at least partially extends out of the first through hole (131) toward a side of the guiding convex rib (12), and in the height direction (Z) of the communication device subrack, projections of two ends of the needle roller (21) at least partially overlap projections of corresponding guiding convex ribs (12) respectively.

5. The communication device subrack according to claim 4, wherein the communication device subrack (10) further comprises a limiting member (3), the limiting member (3) is connected to the body (1), and the limiting member (3) at least partially blocks, in the height direction (Z) of the communication device subrack, a side that is of the first through hole and that is away from the guiding convex rib (12).

6. The communication device subrack according to claim 4, wherein a groove (121) is disposed on one end that is of the guiding convex rib (12) and that is connected to the first bottom plate (13), the groove (121) is in communication with the first through hole (131) in the second direction (Y), and the two ends of the needle roller (21) are rotatably disposed in grooves (121) on the corresponding guiding convex ribs (12) respectively.

7. The communication device subrack according to claim 5, wherein a hollowed portion (14) is disposed on the body (1), and the hollowed portion (14) is disposed between two adjacent sliding grooves (11).

8. The communication device subrack according to claim 7, wherein the limiting member (3) comprises a second bottom plate (31), a first baffle (32), and a second baffle (33), the first baffle (32) and the second baffle (33) are respectively connected to two ends of the second bottom plate (31), the second bottom plate (31) is connected to the first bottom plate (13), the first baffle (32) extends into the hollowed portion (14) on one side of the sliding groove (11) and blocks one end of the needle roller (21) in the second direction (Y), and the second baffle (33) extends into the hollowed portion (14) on the other side of the sliding groove (11) and blocks the other end of the needle roller (21) in the second direction (Y).

9. The communication device subrack according to claim 1, wherein the rotating member (2) is a ball roller (22).

10. The communication device subrack according to claim 9, wherein the communication device subrack (10) further comprises a first support frame (4a), the first support frame (4a) is connected to the body (1), a gap (a) exists between the first support frame (4a) and a bottom surface of the body (1), and the ball roller (22) is rotatably disposed in the gap (a); and
a second through hole (15) is provided on the body (1), a diameter of the second through hole (15) is less than a diameter of the ball roller (22), and the ball roller (22) at least partially extends out of the second through hole (15).

11. The communication device subrack according to claim 10, wherein a flange (151) is disposed at an edge of the second through hole (15), the flange (151) protrudes from a surface that is of the body (1) and that is away from the first support frame (4a), and the ball roller (22) at least partially protrudes from an end face of the flange (151).

12. The communication device subrack according to claim 10 or 11, wherein the first support frame (4a) comprises a mounting plate (4a1) and a support plate (4a2), the mounting plate (4a1) is connected to the support plate (4a2) and is configured to connect to an inner side wall of a chassis body (100) of a communication device, and the gap (a) exists between the body (1) and the support plate (4a2).

13. The communication device subrack according to claim 9, wherein the communication device subrack (10) further comprises a second support frame (4b), the second support frame (4b) is connected to the body (1), a mounting hole (16) is provided on the body (1), an inner diameter of the mounting hole (16) gradually decreases from a side close to the second support frame (4b) to a side away from the second support frame (4b) in the height direction (Z) of the communication device subrack, an inner diameter that is of the mounting hole (16) and that is on the side close to the second support frame (4b) is greater than a diameter of the ball roller (22), and an inner diameter that is of the mounting hole (16) and that is on the side away from the second support frame (4b) is less than the diameter of the ball roller (22), to cause the ball roller (22) to at least partially extend out of the side that is of the mounting hole (16) and that is away from the second support frame (4b).

14. The communication device subrack according to any one of claims 1 to 13, wherein a plurality of rotating members (2) are disposed, and at least a part of the rotating members (2) have different sizes in the height direction (Z) of the communication device subrack.

15. The communication device subrack according to any one of claims 1 to 14, wherein the sliding groove (11) comprises a first support area and a second support area in the first direction (X), and the first support area is closer to an entrance side of the sliding groove (11) than the second support area; and
the plurality of rotating members (2) are disposed, and in the first direction (X), a distance between two adjacent rotating members (2) in the first support area is less than a distance between two adjacent rotating members (2) in the second support area.

16. The communication device subrack according to any one of claims 1 to 15, wherein the communication device subrack further comprises a guiding member (5), the guiding member (5) is connected to the body (1), and the guiding member (5) is aligned with the sliding groove (11) in the first direction (X).

17. The communication device subrack according to any one of claims 1 to 16, wherein the communication device subrack further comprises the chassis body (100), and the body (1) is disposed in the chassis body (100).

18. The communication device subrack according to claim 17, wherein a plurality of bodies (1) are disposed, and the plurality of bodies (1) are symmetrically disposed on an inner wall at the top of the chassis body (100) and an inner wall at the bottom of the chassis body (100).

19. The communication device subrack according to claim 17, wherein a plurality of bodies (1) are disposed, and the plurality of bodies (1) are symmetrically disposed on inner walls of two opposite side walls of the chassis body (100).

20. A communication device, comprising a board (200) and the communication device subrack (10) according to any one of claims 1 to 19, wherein the board (200) is mounted in a sliding groove (11) of the communication device subrack and is supported on a rotating member (2).
